# EUROPÄISCHE PATENTSCHRIFT

(11) **EP 1 863 743 B1**
(45) Veröffentlichungstag und Bekanntmachung des Hinweises auf die Patenterteilung: **16.12.2009**
(21) Anmeldenummer: 06723623.2
(22) Anmeldetag: 22.03.2006
(51) Int. Cl.: C03C 17/34

(54) **BESCHICHTETES SUBSTRAT MIT EINER TEMPORÄREN SCHUTZSCHICHT SOWIE VERFAHREN ZU SEINER HERSTELLUNG**
COATED SUBSTRATE WITH A TEMPORARY PROTECTIVE LAYER AND METHOD FOR PRODUCTION THEREOF
SUBSTRAT REVETU COMPRENANT UNE COUCHE DE PROTECTION TEMPORAIRE, ET PROCEDE POUR LE REALISER

(30) Priorität: 23.03.2005 DE 102005014031
(43) Veröffentlichungstag der Anmeldung: 12.12.2007
(73) Patentinhaber: Leybold Optics GmbH, 63755 Alzenau (DE)
(72) Erfinder: ZÜLTZKE, Walter, 63477 Maintal (DE); FUHR, Markus, 65817 Eppstein (DE); VIET, Manfred, 63755 Alzenau (DE); NAUENBURG, Klaus, 63454 Hanau (DE)
(74) Vertreter: Pohlmann, Bernd Michael
(86) Internationale Anmeldenummer: PCT/EP2006/002629
(87) Internationale Veröffentlichungsnummer: WO 2006/100056

(56) Entgegenhaltungen:
- WO-A-03/057641
- US-A- 6 139 970
- US-B1- 6 287 651
- WOHLRAB C ET AL: "APPLICATION OF PLASMA POLYMERIZATION ON OPHTHALMIC LENSES: EQUIPMENT AND PROCESSES" OPTICAL ENGINEERING, SOC. OF PHOTO-OPTICAL INSTRUMENTATION ENGINEERS. BELLINGHAM, US, Bd. 34, Nr. 9, 1. September 1995 (1995-09-01), Seiten 2712-2718, XP000525029 ISSN: 0091-3286

## Beschreibung

Die Erfindung betrifft ein Verfahren zur Herstellung beschichteter Substrate mit einer temporären Schutzschicht, bei welchem zumindest eine Seite des Substrates mit zumindest einer Funktionsschicht mittels eines CVD- oder PVD-Prozesses beschichtet wird und auf zumindest eine beschichtete Seite des Substrates eine temporäre Schutzschicht aufgebracht wird sowie ein mit einer temporären Schutzschicht beschichtetes Substrat.

Temporäre Schutzschichten, d.h. wieder entfernbare Schichten zum Schutz der Oberflächen von empfindlichen Substraten, insbesondere zum Schutz gegen mechanische Beschädigungen oder chemische Angriffe, sind aus verschiedensten Industriezweigen bekannt. Die Schutzschichten dienen dabei dem Schutz der Oberflächen während der weiteren Bearbeitung und/oder während des Transports und/oder während der Lagerung der Substrate bis zu deren bestimmungsgemäßen Einsatz.

Typische Schutzschichten bestehen dabei aus Polymeren oder Wachsen. Zur Entfernung derartiger Schichten werden organische oder anorganische Lösungen, beispielsweise saure oder alkalische Lösungen, Hydrocarbonate oder Alkohollösungen verwendet. Diese Lösungen haben jedoch den Nachteil, dass sie für viele Substratmaterialien und/oder Beschichtungsmaterialien unverträglich sind und diese angreifen. Insbesondere für transparente Substrate aus Glas oder Kunststoff mit verschiedensten Funktionsschichten sind derartige temporäre Schutzschichten ungeeignet.

Die WO 01/02496 offenbart eine Schutzschicht aus Kohlenstoff, welche durch Auftragen einer flüssigen polymerischen Schichtzusammensetzung auf das Substrat bzw. beschichtete Substrat und durch anschließendes Abbinden bzw. Trocknen der Schichtzusammensetzung gebildet wird. Diese Schutzschicht dient insbesondere dem mechanischen Schutz von Glassubstraten mit verschiedensten Funktionsschichten. Die Schutzschicht kann durch eine geeignete Flüssigkeit, insbesondere Wasser, abgespült oder durch Verbrennung wieder entfernt werden. In vielen praktischen Anwendungsfällen werden die sehr dünnen Funktionsschichten in einer Vakuumkammer mittels CVD (Chemical vapor deposition) oder PVD (physical vapor deposition) auf die Substrate aufgebracht. Das anschließende Aufbringen der Schutzschicht gemäß der WO 01/02496 erfordert einen hohen Aufwand, da die Substrate aus der Vakuumkammer entfernt und in einer weiteren Bearbeitungsstation behandelt werden müssen. Das Verfahren ist insbesondere dann ungeeignet, wenn die Substrate, beispielsweise zur Beschichtung der Rückseite, schon mit einer Schutzschicht auf der beschichteten Vorderseite versehen sind und zur weiteren Beschichtung wiederum in eine Vakuumkammer überführt werden müssen.

Das ist beispielsweise bei der Beschichtung optischer Substrate, insbesondere von Linsen der Fall. Diese werden beidseitig mit optischen Funktionsschichten und/oder Kratzschutzschichten und einer abschließenden hydrophoben und/oder oleophoben Cleancoatschichten mittels reaktiver Prozesse im Vakuum versehen. Dabei ist die Cleancoatschicht besonders empfindlich gegen Einwirkungen reaktiver Komponenten. In der WO 03/057641 A1 wird zum Schutz der bereits auf einer Seite des Substrates vorhandenen hydrophoben und/oder oleophoben Beschichtung diese vor der weiteren Behandlung der anderen Seite des Substrates in der Vakuumkammer mit einer temporären dünnen Schutzschicht aus einem Metallfluorid, insbesondere aus MgF₂, LaF₃ oder CeF₃, versehen. Die Metallfluoride können dabei ebenfalls in der Vakuumkammer aufgedampft werden. Die temporäre Schutzschicht kann anschließend abgewischt werden. Das ist wiederum mit einem hohen Aufwand verbunden. Außerdem kann beim Abwischen der Schutzschicht eine darunter liegende, sehr empfindliche hydrophobe und/oder oleophobe Cleancoatschicht beschädigt werden.

Aufgabe der Erfindung ist es daher, ein einfaches und ökonomisches Verfahren zur Herstellung von beschichteten Substraten mit einer leicht zu entfernenden temporären Schutzschicht sowie ein beschichtetes Substrat mit einer leicht zu entfernenden Schutzschicht bereitzustellen.

Die Lösung der Aufgabe gelingt mit einem Verfahren gemäß Anspruch 1 und einem beschichteten Substrat gemäß Anspruch 14 Weitere vorteilhafte Ausgestaltungen sind in den jeweiligen Unteransprüchen ausgeführt.

Im erfindungsgemäßen Verfahren zur Herstellung eines beschichteten Substrates wird auf das Substrat zumindest eine Funktionsschicht mit Hilfe chemischer oder physikalischer Abscheidung eines Beschichtungsmaterials aus der Dampfphase aufgebracht und auf die Funktionsschicht eine temporäre Schutzschicht durch Verdampfen von einem leicht in Wasser oder in einem polaren organischen oder protischen organischen Lösungsmittel löslichen Salz und/oder durch Verdampfen einer Verbindung, welche eine leicht in Wasser, in einem polaren organischen oder protischen organischen Lösungsmittel lösliche salzartige Schicht bildet, aufgebracht wird.

Unter leicht in Wasser oder in einem polaren organischen oder protischen organischen Lösungsmittel löslich im Sinne dieser Erfindung ist eine Löslichkeit von mehr als 1 g je 100 cm³ Lösungsmittel bei Raumtemperatur.

In der Ausführung des Verfahrens wird ein salzartiges Alkalimetall-Halogenid, insbesondere Natriumchlorid zum Aufbringen der temporären Schutzschicht verdampft.

Alkalimetall-Halogenide sind chemische Verbindungen der Halogene, d.h. der Elemente der 7. Hauptgruppe (Fluor, Chlor, Brom, Iod, Astad) mit Alkalimetallen, d.h. Elementen der 1. Hauptgruppe (Litium, Natrium, Kalium, Rubidium, Cäsium, Francium).

Die Schutzschicht ist nur temporär, d.h. für einen vorübergehenden Zeitraum, in dem die darunter liegenden Schichten zu schützen sind, aufgebracht und wieder leicht zu entfernen, ohne die darunter befindliche Fläche negativ zu beeinflussen. Eine Entfernung der salzartigen Alkalimetall-Halogenid- Schutzschicht gelingt vorzugsweise durch Abspülen mit einer polaren Flüssigkeit, insbesondere mit Wasser.

In einer vorteilhaften Ausführungsform der Erfindung werden sowohl die Funktionsschicht bzw. Funktionsschichten als auch die Schutzschicht durch Verdampfen mit einem thermisch beheizten Widerstandsverdampfer oder einem Elektronenstrahlverdampfer aufgebracht, so dass die Beschichtung in einer Vakuumkammer erfolgen kann.

Als erste Funktionsschicht wird vorzugsweise eine optisch wirksame Schicht aus mehreren Einzelschichten, eine sogenannte Multilayer-Schicht und/oder eine Kratzschutzschicht, welche Metalle oder Metallverbindungen, insbesondere Metalloxide umfassen, aufgebracht.

Auf die erste Funktionsschicht und/oder auf das Substrat wird in einer weiteren Ausführung eine zweite, hydrophobe und/oder oleophobe Funktionsschicht als sogenannte Cleancoatschicht mit stark glättender Wirkung, aufgebracht. Diese zweite Funktionsschicht wird vorzugsweise durch Verdampfen von organischen Siliziumverbindungen oder fluorierten Kohlenwasserstoffverbindungen aufgebracht. Die organischen Siliziumverbindungen oder fluorierten Kohlenwasserstoffverbindungen umfassen vorzugsweise zumindest teilweise perfluorierte Kohlenstoffatome oder -ketten. Vorzugsweise können die organischen Siliziumverbindungen oder fluorierten Kohlenwasserstoffverbindungen zusätzlich gesättigte, aliphatische Kohlenstoffatome oder .-ketten und/oder sauerstoff- und stickstoffhaltige funktionelle Gruppen aufweisen.

Zur Verbesserung der Haftfähigkeit der Funktionsschichten auf dem Substrat ist es dabei vorteilhaft, wenn das Substrat vor dem Aufbringen einer Funktionsschicht mit einem Plasma- oder Ionenstrahl behandelt wird und/oder die erste Funktionsschicht zur Beeinflussung von Schichteigenschaften mit einem plasma- oder ionenstrahlunterstützten Prozess aufgebracht wird.

In einer weiteren Ausgestaltung des erfindungsgemäßen Verfahrens wird das Substrat beidseitig behandelt und/oder beschichtet, wobei in einem ersten Schritt die Vorderseite des Substrates mit einem Plasma- oder Ionenstrahl behandelt wird und/oder mit zumindest einer Funktionsschicht beschichtet wird sowie anschließend mit der temporären Schutzschicht beschichtet wird. Bei einer Behandlung und/oder Beschichtung der Rückseite des Substrates in einem zweiten Schritt ist dabei die zuerst beschichtete Vorderseite des Substrates durch die temporäre Schutzschicht geschützt. Das ist insbesondere dann von Vorteil, wenn die Behandlung und/oder Beschichtung der Rückseite des Substrates unter Einwirkung von Ionen oder eines Plasmas erfolgt.

Die Dicke der Schutzschicht ist dabei abhängig von der Eindringtiefe der Ladungsträger in die Schicht und wird vorzugsweise so gewählt, dass die darunter liegenden Flächen oder Funktionsschichten nicht beeinflusst werden können.

Für die Durchführung des erfindungsgemäßen Verfahrens können beliebige Vakuumbeschichtungsanlage genutzt werden, die zum Aufdampfen der Schutzschicht mit einem geeigneten Verdampfer ausgestattet sind.

Das erfindungsgemäße, vorzugsweise mit dem erfindungsgemäßen Verfahren hergestellte, beschichtete Substrat umfasst zumindest eine Funktionsschicht und eine auf die Funktionsschicht aufgebrachte temporäre Schutzschicht, die ein Salz oder eine salzartige Verbindung umfasst, welche leicht in einem polaren oder protischen organischen Lösungsmittel löslich sind.

In der Ausführung umfasst die temporäre Schutzschicht ein Alkalimetall-Halogenid, vorzugsweise Natriumchlorid. Eine temporäre Schutzschicht aus Natriumchlorid ist leicht aufbringbar durch Verdampfen und lässt sich mit Wasser wieder leicht abspülen ohne darunter liegende sehr empfindliche Funktionsschichten negativ zu beeinflussen.

Die Schutzschicht weist vorzugsweise eine Dicke von 5 nm bis 100 nm, insbesondere von 10 nm, auf.

Die Funktionsschichten können dabei vorzugsweise als optisch wirksame Funktionsschichten und/oder Kratzschutzschichten und/oder hydrophobe und/oder oleophobe Funktionsschichten ausgebildet sein und sowohl einseitig, als auch auf einer Vor- und einer Rückseite des Substrates aufgebracht sein. Ebenso kann die temporäre Schutzschicht einseitig, aber auch auf einer beschichteten Vor- und einer beschichteten oder unbeschichteten Rückseite des Substrates aufgebracht sein.

Die Erfindung wird im weiteren an Hand eines Ausführungsbeispiels näher erläutert. Es zeigen dazu:
- Fig. 1: ein beschichtetes Substrat
- Fig. 2: eine schematische Darstellung einer Beschichtungsanordnung
- Fig. 3: eine Halterung für das Substrat
- Fig. 4: die Bewegung von Ladungsträgern

Im Ophtalmic-Bereich sind beispielsweise zur Herstellung von Brillengläsern Substrate aus Glas oder Kunststoff beidseitig mit Antireflexschichten und Cleancoatschichten zu versehen.

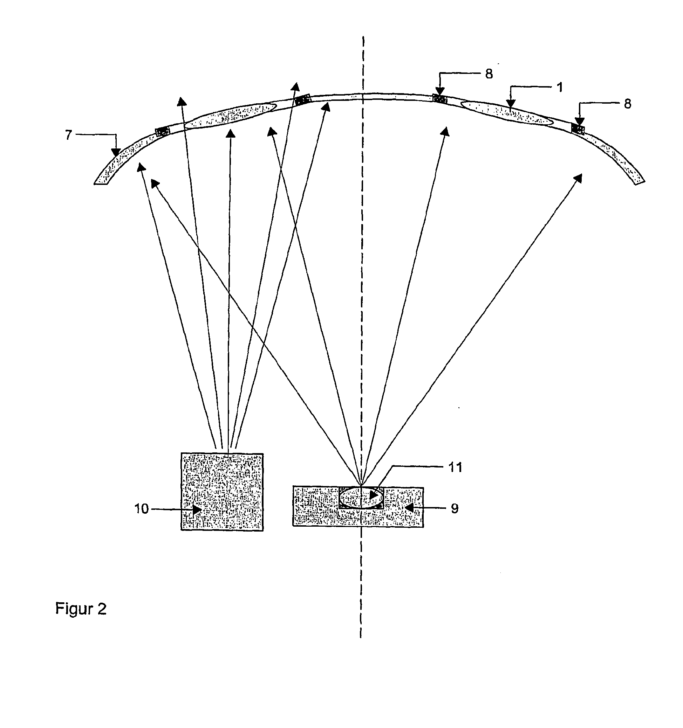

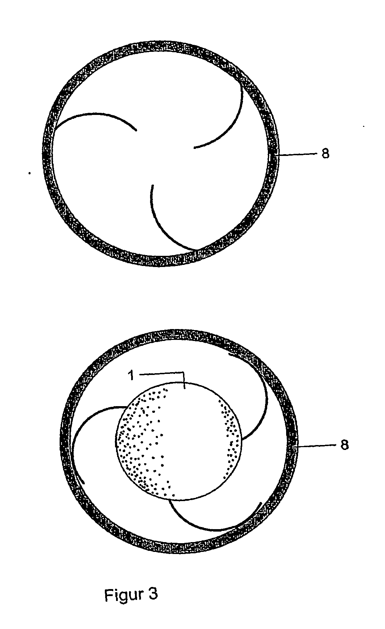

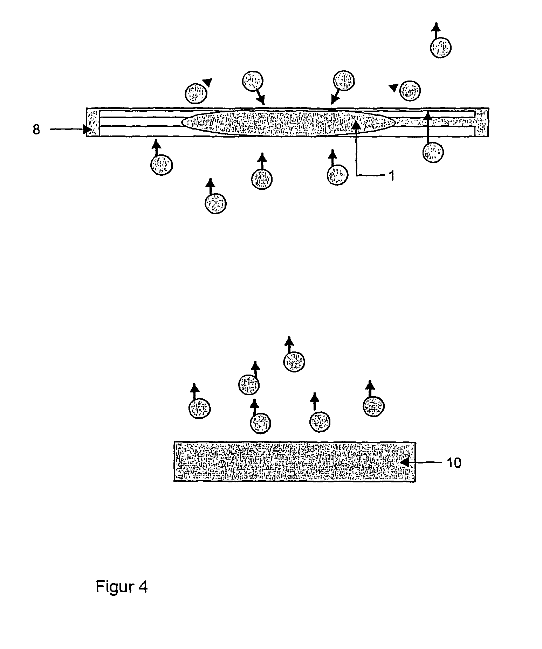

Zur Herstellung der Brillengläser werden mehrere Substrate 1 zur Beschichtung, wie in Fig.2 dargestellt, in einer Vakuumkammer (nicht dargestellt) auf einem kalottenförmigen, um eine Achse drehbaren Substrathalter 7 angeordnet. In der Vakuumkammer ist unterhalb des Substrathalters 7 eine Ionen-/Plasmaquelle 10 angeordnet. Diese dient der Bestrahlung der Substratoberfläche mit einem Plasma-/lonenstrahl vor der Beschichtung, um eine bessere Haftung zu gewährleisten und der Bestrahlung der aufwachsenden Schicht während der Beschichtung zur Beeinflussung der Schichteigenschaften. Außerdem ist in der Vakuumkammer ein Elektronenstrahlverdampfer **9** unterhalb des Substrathalters **7** angeordnet, der das jeweils für die aufzubringende Schicht notwendige Beschichtungsmaterial **11** verdampft. Zur Halterung der Substrate **1** auf dem Substrathalter **7** werden die in Fig. 3 und 4 gezeigten Substrat-Federringe **8** eingesetzt. Zwischen dem gehalterten Substrat **1** und dem Substrat-Federring **8** ist dabei ein Spalt ausgebildet, der bei einer Beschichtung oder einer Behandlung einer Vorderseite des Substrates **1** mit Plasma- oder Ionenstrahlen den Ladungsträgern ungehindert Zugang zur Rückseite des Substrates **1** gewährt.

In einem ersten Verfahrensschritt werden die Vorderseiten **5** der Substrate **1** in einer evakuierten Vakuumkammer beschichtet. Dazu werden die im Substrathalter **7** gehalterten Substrate **1** mittels eines Ionenstrahls vorbehandelt. Als erste Funktionsschicht **2** wird eine Antireflexschicht aus mehreren Einzelschichten aus beispielsweise Titanoxiden, Zirkonoxiden, Tantaloxiden, Aluminiumoxiden, Siliziumoxiden mittels des Elektronenstrahlverdampfers **9** aufgedampft. Die Beschichtung der Substrate **1** mit der ersten, aus mehreren Einzelschichten bestehenden Funktionsschicht **2** erfolgt mit Unterstützung eines Ionenstrahls. Der Austausch der Beschichtungsmaterialien **11** zur Erzeugung der verschiedenen Schichten erfolgt durch einen Drehtiegel. Als zweite und letzte Funktionsschicht **3** wird eine hydrophobe Cleancoatschicht mittels des Elektronenstrahlverdampfers **9** auf die erste Funktionsschicht **2** aufgedampft.

Würde an dieser Stelle das Substrat **1** bereits gewendet und von seiner Rückseite **6** wie vor beschrieben beschichtet, würde die sehr empfindliche Cleancoatschicht durch die oben beschriebene und in Fig. 4 gezeigte Einwirkung von Ladungsträgern wieder zerstört werden.

Um dies zu verhindern, wird bei der Beschichtung der Vorderseite **5** des Substrates **1** im ersten Verfahrensschritt eine weitere Schicht als Schutzschicht **4** aufgedampft. Die temporäre Schutzschicht **4** wird durch Verdampfen von reinem Natriumchlorid mittels des Elektronenstrahlverdampfers **9** hergestellt.

Nach einem Entlüften der Vakuumkammer werden die Substrate **1** auf dem Substrathalter **7** zur Beschichtung der Rückseite **6** gewendet. In einem zweiten Verfahrensschritt werden dann die Rückseiten **6** der Substrate **1** in der erneut evakuierten Vakuumkammer, wie vor beschrieben, mit einer ersten und zweiten Funktionsschicht **2, 3** beschichtet.

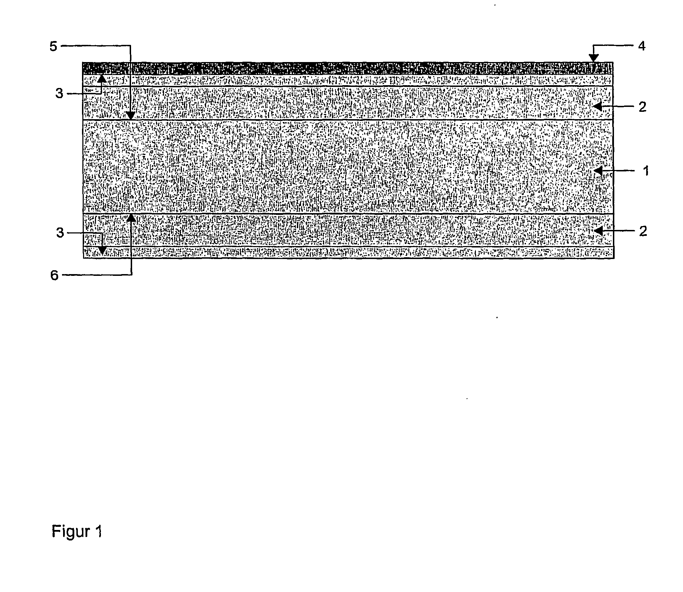

In Fig. 1 zeigt die schematische Darstellung eines wie vor beschriebenen beschichteten Substrates **1**. Die auf die Vorderseite **5** und Rückseite **6** des Substrates **1** aufgebrachte erste Funktionsschicht **2** ist eine Antireflexschicht aus mehreren Einzelschichten aus z.B. Titanoxiden, Zirkonoxiden, Tantaloxiden, Aluminiumoxiden, Siliziumoxiden und weist eine Dicke von 100 - 500 nm auf. Die ebenfalls auf die Vorderseite **5** und Rückseite **6** des Substrates **1** aufgebrachte zweite und letzte Funktionsschicht **3** ist eine Cleancoatschicht und weist eine Dicke von 25 nm auf. Die lediglich auf die Vorderseite **5** des Substrates **1** aufgedampfte Schutzschicht aus Natriumchlorid weist eine Dicke von 10 nm auf und ist geeignet das Eindringen von Ladungsträgern bis zur Cleancoatschicht während der Beschichtung der Rückseite **6** des Substrates **1** zu verhindern.

Nach der Beschichtung der Rückseite **6** des Substrates **1** wird die Schutzschicht **4** wieder entfernt. Die Schutzschicht **4** aus Natriumchlorid ist langfristig nicht stabil und weist keine gute Haftung auf der darunter liegenden Cleancoatschicht auf und ist somit durch Abspülen mit Wasser sehr leicht zu entfernen, ohne die Cleancoatschicht zu beschädigen. Nach dem Entfernen der Schutzschicht **4** ist das hydrophobe Verhalten der Cleancoatschicht wieder vollständig gegeben.

Die Ränder der mit einer Cleancoatschicht beschichteten Substrate **1** müssen für die Herstellung von Brillengläsern weiter bearbeitet werden. Da die Cleancoatschicht eine sehr hohe Oberflächenglätte erzeugt, haften die Klebepads für die Substratrandbearbeitung nicht mehr ausreichen. Häufig verrutscht das beschichtete Substrat **1** beim Einschleifen um seine Achse und kann dann nicht mehr verwendet werden.

Wird in diesem Fall das Substrat **1** bei der Beschichtung beidseitig mit einer temporären Schutzschicht **4** versehen, können die Klebepads für die Substratrandbearbeitung wieder gut haften. Nach der Substratrandbearbeitung kann dann die beidseitige temporäre Schutzschicht **4** wie oben beschrieben wieder entfernt werden.

### BEZUGSZEICHENLISTE

- 1: Substrat
- 2: erste Funktionsschicht
- 3: zweite Funktionsschicht
- 4: Schutzschicht
- 5: Vorderseite
- 6: Rückseite
- 7: Substrathalter
- 8: Substrat-Federring
- 9: Elektronenstrahlverdampfer
- 10: Ionen-/Plasmaquelle
- 11: Beschichtungsmaterial

## Patentansprüche

1. Verfahren zur Herstellung eines beschichteten Substrates (1), bei welchem auf das Substrat (1) zumindest eine Funktionsschicht (2, 3) durch chemische oder physikalische Abscheidung eines Beschichtungsmaterials aus der Dampfphase aufgebracht und auf zumindest eine Funktionsschicht (2, 3) eine temporäre Schutzschicht (4) aufgebracht wird, **dadurch gekennzeichnet, dass** zum Aufbringen der temporären Schutzschicht (4) Natriumchlorid verdampft wird.

2. Verfahren nach Anspruch 1, **dadurch gekennzeichnet, dass** die temporäre Schutzschicht (4) durch Verdampfen mit einem thermisch beheizten Widerstandsverdampfer oder einen Elektronenstrahlverdampfer (9) aufgebracht wird.

3. Verfahren nach einem der vorhergehenden Ansprüche, **dadurch gekennzeichnet, dass** die temporäre Schutzschicht (4) mit einer Dicke von 5 nm bis 100 nm, insbesondere von 10 nm, aufgebracht wird.

4. Verfahren nach einem der vorhergehenden Ansprüche, **dadurch gekennzeichnet, dass** zumindest eine erste Funktionsschicht (2), welche zumindest ein Metall oder zumindest eine Metallverbindung umfasst, aufgebracht wird.

5. Verfahren nach Anspruch 4, **dadurch gekennzeichnet, dass** als erste Funktionsschicht (2) eine Multi-Layerschicht aus unterschiedlichen Metallen oder Metallverbindungen aufgebracht wird.

6. Verfahren nach Anspruch 4 oder 5, **dadurch gekennzeichnet, dass** die erste Funktionsschicht (2) durch Verdampfen eines Beschichtungsmaterials (11) mit einem thermisch beheizten Widerstandsverdampfer oder einen Elektronenstrahlverdampfer (9) aufgebracht wird.

7. Verfahren nach einem der Ansprüche 4 bis 6, **dadurch gekennzeichnet, dass** die erste Funktionsschicht (2) mittels eines plasma- oder ionenstrahlunterstützten Prozess aufgebracht wird.

8. Verfahren nach einem der vorhergehenden Ansprüche, **dadurch gekennzeichnet, dass** das Substrat (1) vor dem Aufbringen einer ersten Funktionsschicht (2) mit einem Plasma-oder Ionenstrahl behandelt wird.

9. Verfahren nach einem der vorhergehenden Ansprüche, **dadurch gekennzeichnet, dass** auf das Substrat (1) oder die erste Funktionsschicht (2) eine zweite, hydrophobe und/oder oleophobe Funktionsschicht (3) aufgebracht wird.

10. Verfahren nach Anspruch 9, **dadurch gekennzeichnet, dass** auf das Substrat (1) oder die erste Funktionsschicht (2) eine zweite, hydrophobe und/oder oleophobe Funktionsschicht (3), umfassend zumindest eine siliziumorganische Verbindung , welche zumindest teilweise perfuorierte Kohlenstoffatome oder -ketten aufweist, aufgebracht wird

11. Verfahren nach einem der Ansprüche 9 oder 10, **dadurch gekennzeichnet, dass** die zweite, hydrophobe und/oder oleophobe Funktionsschicht (3) durch Verdampfen eines Beschichtungsmaterials mit einem thermisch beheizten Widerstandsverdampfer oder einen Elektronenstrahlverdampfer (9) aufgebracht wird.

12. Verfahren nach einem der vorhergehenden Ansprüche, **dadurch gekennzeichnet, dass** das Substrat (1) in einem ersten Schritt
- auf seiner Vorderseite (5) mit einem Plasma- oder Ionenstrahl behandelt wird und/oder
- zumindest eine Funktionsschicht (2, 3) aufgebracht wird und
- die temporären Schutzschicht (4) aufgebracht wird
und in einem zweiten Schritt
- auf seiner Rückseite (6) mit einem Plasma- oder Ionenstrahl behandelt wird und/oder
- zumindest eine Funktionsschicht (2, 3) und/oder
- eine temporäre Schutzschicht (4) aufgebracht wird.

13. Verfahren nach Anspruch 12, **dadurch gekennzeichnet, dass** das Substrat (1) zwischen dem ersten und dem zweiten Schritt innerhalb einer Vakuumkammer gewendet wird.

14. Beschichtetes Substrat, zumindest umfassend eine Funktionsschicht (2, 3) und eine auf die Funktionsschicht (2, 3) aufgebrachte temporäre Schutzschicht (4), **dadurch gekennzeichnet, dass** die temporäre Schutzschicht (4) ein salzartiges Alkalimetall-Halogenid, insbesondere Natriumchlorid, umfasst.

15. Beschichtetes Substrat nach Anspruch 14, **dadurch gekennzeichnet, dass** die temporäre Schutzschicht (4) eine Dicke von 5 nm bis 100 nm, insbesondere von 10 nm, aufweist.

16. Beschichtetes Substrat nach einem der vorhergehenden Ansprüche 14 bis 15, **dadurch gekennzeichnet, dass** eine erste Funktionsschicht (2) zumindest ein Metall oder zumindest eine Metallverbindung umfasst.

17. Beschichtetes Substrat nach einem der vorhergehenden Ansprüche 14 bis 15, **dadurch gekennzeichnet, dass** die erste Funktionsschicht (2) eine Multi-Layerschicht aus unterschiedlichen Metallen oder Metallverbindungen umfasst.

18. Beschichtetes Substrat nach einem der vorhergehenden Ansprüche 14 bis 17, **dadurch gekennzeichnet, dass** auf das Substrat (1) oder die erste Funktionsschicht (2) eine zweite, hydrophobe und/oder oleophobe Funktionsschicht (3) aufgebracht ist.

19. Beschichtetes Substrat nach Anspruch 18, **dadurch gekennzeichnet, dass** auf das Substrat (1) oder die erste Funktionsschicht (2) eine zweite, hydrophobe und/oder oleophobe Funktionsschicht (3), umfassend zumindest eine siliziumorganische Verbindung, welche zumindest teilweise perfluorierte Kohlenstoffatome oder -ketten aufweist, aufgebracht ist.

20. Beschichtetes Substrat nach einem der vorhergehenden Ansprüche 15 bis 18, **dadurch gekennzeichnet, dass** das Substrat (1) auf seiner Vorderseite (5) zumindest eine Funktionsschicht (2, 3) und eine temporäre Schutzschicht (4) aufweist und in auf seiner Rückseite (6) zumindest eine Funktionsschicht (2, 3) und/oder eine temporäre Schutzschicht (4) aufweist.

21. Beschichtetes Substrat nach einem der vorhergehenden Ansprüche 15 bis 20, **dadurch gekennzeichnet, dass** das Substrat (1) ein transparentes Material umfasst.

22. Beschichtetes Substrat nach Anspruch 21, **dadurch gekennzeichnet, dass** das Substrat (1) ein Glas oder einen Kunststoff umfasst.

## Claims

1. Method for producing a coated substrate (1) in which at least one functional layer (2, 3) is applied to the substrate (1) from the vapor phase by means of chemical or physical deposition of a coating material and a temporary protective layer (4) is applied to at least one functional layer (2, 3), **characterized in that** sodium chloride is evaporated to apply the temporary protective layer (4) .

2. Method according to Claim 1, **characterized in that** the temporary protective layer (4) is applied by evaporating with a thermally heated resistance evaporator or an electron beam evaporator (9).

3. Method according to one of the preceding claims, **characterized in that** the temporary protective layer (4) is applied with a thickness of 5 nm to 100 nm, in particular of 10 nm.

4. Method according to one of the preceding claims, **characterized in that** at least one first functional layer (2), which comprises at least one metal or at least one metal compound, is applied.

5. Method according to Claim 4, **characterized in that** a multilayer coat of various metals one metal compound is applied as the first functional layer (2).

6. Method according to Claim 4 or 5, **characterized in that** the first functional layer (2) is applied by evaporating a coating material (11) with a thermally heated resistance evaporator or an electron beam evaporator (9).

7. Method according to one of Claims 4 to 6, **characterized in that** the first functional layer (2) is applied by means of a plasma- or ion-beam sister the process.

8. Method according to one of the preceding claims, **characterized in that** the substrate (1) is treated with a plasma or ion beam before the application of a first functional layer (2).

9. Method according to one of the preceding claims, **characterized in that** a second, hydrophobic and/or oleophobic functional layer (3) is applied to the substrate (1) or the first functional layer (2).

10. Method according to Claim 9, **characterized in that** a second, hydrophobic and/or oleophobic functional layer (3), comprising at least one silicon-organic compound which comprises at least partly perfluorinated hydrocarbon atoms or chains is applied to the substrate (1) or the first functional layer (2).

11. Method according to either of Claims 9 and 10, **characterized in that** the second, hydrophobic and/or oleophobic functional layer (3) is applied by evaporating a coating material with a thermally heated resistance evaporator or an electron beam evaporator (1).

12. Method according to one of the preceding claims, **characterized in that**, in a first step, the substrate (1)
- is treated on its front side (5) with a plasma or ion beam and/or
- at least one functional layer (2, 3) is applied and
- the temporary protective layer (4) is applied
and, in a second step, said substrate
- is treated on its rear side (6) with a plasma or ion beam and/or
- at least one functional layer (2, 3) and/or
- a temporary protective layer (4) is applied.

13. Method according to Claim 12, **characterized in that** the substrate (1) is turned inside a vacuum chamber between the first step and the second step.

14. Coated substrate, at least comprising a functional layer (2, 3) and a temporary protective layer (4) applied to the functional layer (2, 3), **characterized in that** the temporary protective layer (4) comprises a salt-like alkali metal halide, in particular sodium chloride.

15. Coated substrate according to Claim 14, **characterized in that** the temporary protective layer (4) has a thickness of 5 nm to 100 nm, in particular of 10 nm.

16. Coated substrate according to one of the preceding Claims 14 to 15, **characterized in that** a first functional layer (2) comprises at least one metal or at least one metal compound.

17. Coated substrate according to one of the preceding Claims 14 to 15, **characterized in that** the first functional layer (2) comprises a multilayer coat of various metals or metal compounds.

18. Coated substrate according to one of the preceding Claims 14 to 17, **characterized in that** a second, hydrophobic and/or oleophobic functional layer (3) is applied to the substrate (1) or the first functional layer (2).

19. Coated substrate according to Claim 18, **characterized in that** a second, hydrophobic and/or oleophobic functional layer (3), comprising at least one silicon-organic compound which comprises at least partly perfluorinated hydrocarbon atoms or chains is applied to the substrate (1) or the first functional layer (2).

20. Coated substrate according to one of the preceding Claims 15 to 18, **characterized in that** the substrate (1) has at least one functional layer (2, 3) and a temporary protective layer (4) on its front side (5) and at least one functional layer (2, 3) and/or a temporary protective layer (4) on its rear side (6).

21. Coated substrate according to one of the preceding Claims 15 to 20, **characterized in that** the substrate (1) comprises a transparent material.

22. Coated substrate according to Claim 21, **characterized in that** the substrate (1) comprises a glass or a plastic.

## Revendications

1. Procédé de fabrication d'un substrat revêtu (1), selon lequel au moins une couche fonctionnelle (2, 3) est appliquée sur le substrat (1) par dépôt chimique ou physique d'un matériau de revêtement à partir de la phase gazeuse et une couche de protection temporaire (4) est appliquée sur la ou les couches fonctionnelles (2, 3), **caractérisé en ce que** du chlorure de sodium est vaporisé pour l'application de la couche de protection temporaire (4).

2. Procédé selon la revendication 1, **caractérisé en ce que** la couche de protection temporaire (4) est appliquée par vaporisation avec un vaporisateur chauffé thermiquement par résistance ou un vaporisateur à faisceau d'électrons (9).

3. Procédé selon l'une quelconque des revendications précédentes, **caractérisé en ce que** la couche de protection temporaire (4) est appliquée avec une épaisseur de 5 nm à 100 nm, notamment de 10 nm.

4. Procédé selon l'une quelconque des revendications précédentes, **caractérisé en ce qu'**au moins une première couche fonctionnelle (2), qui comprend au moins un métal ou au moins un composé métallique, est appliquée.

5. Procédé selon la revendication 4, **caractérisé en ce qu'**une couche multicouche à base de différents métaux ou composés métalliques est appliquée en tant que première couche fonctionnelle (2).

6. Procédé selon la revendication 4 ou 5, **caractérisé en ce que** la première couche fonctionnelle (2) est appliquée par vaporisation d'un matériau de revêtement (11) avec un vaporisateur chauffé thermiquement par résistance ou un vaporisateur à faisceau d'électrons (9).

7. Procédé selon l'une quelconque des revendications 4 à 6, **caractérisé en ce que** la première couche fonctionnelle (2) est appliquée au moyen d'un procédé assisté par un faisceau plasma ou ionique.

8. Procédé selon l'une quelconque des revendications précédentes, **caractérisé en ce que** le substrat (1) est traité avec un faisceau plasma ou ionique avant l'application d'une première couche fonctionnelle (2).

9. Procédé selon l'une quelconque des revendications précédentes, **caractérisé en ce qu'**une seconde couche fonctionnelle hydrophobe et/ou oléophobe (3) est appliquée sur le substrat (1) ou la première couche fonctionnelle (2).

10. Procédé selon la revendication 9, **caractérisé en ce qu'**une seconde couche fonctionnelle hydrophobe et/ou oléophobe (3), comprenant au moins un composé de silicium organique, qui comporte des chaînes ou des atomes de carbone au moins partiellement perfluorés, est appliquée sur le substrat (1) ou la première couche fonctionnelle (2).

11. Procédé selon l'une quelconque des revendications 9 ou 10, **caractérisé en ce que** la seconde couche fonctionnelle hydrophobe et/ou oléophobe (3) est appliquée par vaporisation d'un matériau de revêtement avec un vaporisateur chauffé thermiquement par résistance ou un vaporisateur à faisceau d'électrons (9).

12. Procédé selon l'une quelconque des revendications précédentes, **caractérisé en ce que** le substrat (1) lors d'une première étape
- est traité sur son recto (5) avec un faisceau plasma ou ionique et/ou
- au moins une couche fonctionnelle (2, 3) est appliquée et
- la couche de protection temporaire (4) est appliquée
et lors d'une seconde étape
- est traité sur son verso (6) avec un faisceau plasma ou ionique et/ou
- au moins une couche fonctionnelle (2, 3) et/ou
- une couche de protection temporaire (4) est appliquée.

13. Procédé selon la revendication 12, **caractérisé en ce que** le substrat (1) est tourné dans une chambre sous vide entre la première et la seconde étape.

14. Substrat revêtu, comprenant au moins une couche fonctionnelle (2, 3) et une couche de protection temporaire (4) appliquée sur la couche fonctionnelle (2, 3), **caractérisé en ce que** la couche de protection temporaire (4) comprend un halogénure de métal alcalin salin, notamment du chlorure de sodium.

15. Substrat revêtu selon la revendication 14, **caractérisé en ce que** la couche de protection temporaire (4) présente une épaisseur de 5 nm à 100 nm, notamment de 10 nm.

16. Substrat revêtu selon l'une quelconque des revendications 14 à 15 précédentes, **caractérisé en ce qu'**une première couche fonctionnelle (2) comprend au moins un métal ou au moins un composé métallique.

17. Substrat revêtu selon l'une quelconque des revendications 14 à 15 précédentes, **caractérisé en ce que** la première couche fonctionnelle (2) comprend une couche multicouche à base de différents métaux ou composés métalliques.

18. Substrat revêtu selon l'une quelconque des revendications 14 à 17 précédentes, **caractérisé en ce qu'**une seconde couche fonctionnelle hydrophobe et/ou oléophobe (3) est appliquée sur le substrat (1) ou la première couche fonctionnelle (2).

19. Substrat revêtu selon la revendication 18, **caractérisé en ce qu'**une seconde couche fonctionnelle hydrophobe et/ou oléophobe (3), comprenant au moins un composé de silicium organique, qui comporte des chaînes ou des atomes de carbone au moins partiellement perfluorés, est appliquée sur le substrat (1) ou la première couche fonctionnelle (2).

20. Substrat revêtu selon l'une quelconque des revendications 15 à 18 précédentes, **caractérisé en ce que** le substrat (1) comporte sur son verso (5) au moins une couche fonctionnelle (2, 3) et une couche de protection temporaire (4) et sur son recto (6) au moins une couche fonctionnelle (2, 3) et/ou une couche de protection temporaire (4).

21. Substrat revêtu selon l'une quelconque des revendications 15 à 20 précédentes, **caractérisé en ce que** le substrat (1) comprend un matériau transparent.

22. Substrat revêtu selon la revendication 21, **caractérisé en ce que** le substrat (1) comprend un verre ou un plastique.
